# EUROPEAN PATENT APPLICATION

(11) **EP 0 562 629 A2**
(43) Date of publication of application: **29.09.1993**
(21) Application number: 93105051.2
(22) Date of filing: 26.03.1993
(51) Int. Cl.: H01L 23/498, H01L 23/14, H01L 23/64

(54) **Semiconductor device comprising a package**

(30) Priority: 26.03.1992 JP 68649/92; 31.03.1992 JP 77100/92; 10.04.1992 JP 91021/92; 20.04.1992 JP 99705/92
(71) Applicant: SUMITOMO ELECTRIC INDUSTRIES, LIMITED, Osaka 541 (JP)
(72) Inventor: Takikawa, Takatoshi, c/o Itami Works of Sumitomo, Itami-shi, Hyogo (JP); Yamanaka, Shosaku, c/o Itami Works of Sumitomo, Itami-shi, Hyogo (JP); Maeda, Takao, c/o Itami Works of Sumitomo, Itami-shi, Hyogo (JP); Harada, Keizo, c/o Itami Works of Sumitomo, Itami-shi, Hyogo (JP); Ban, Shunsuke, c/o Itami Works of Sumitomo, Itami-shi, Hyogo (JP)
(74) Representative: Schieschke, Klaus, Dipl.-Ing.

(57) **Abstract**

A semiconductor device which can reduce noise, which can be used for a variety of different purposes in a flexible manner, and which is suitable for automatic assembly. It has a metal board (1) carrying a semiconductor device chip (6) on the central part thereof. An insulating layer (2), a ceramic laminated wiring board (3), an organic film (4), and a lead frame (5) are laminated one on another on the metal board so as to surround the semiconductor device chip. The lead frame is connected to the semiconductor device chip through the ceramic laminated wiring board. The assembly thus formed is sealed with a synthetic resin.

## Description

This invention relates to a semiconductor device carrying a semiconductor device chip operating a high speed for use in a microprocessor, a memory device, etc.

Today's semiconductor device chips used mainly in microprocessors have increased numbers of signal inputs and outputs and operate at high speed. This has caused the problem of noises such as switching noises produced during switching of the device chips, reflection noises produced at the wiring ends and cross-talks produced between wirings. Further since the electric power consumed by those device chips are rather large, it is becoming an important problem how the heat produced in the semiconductor device should be released.

Heretofore, it was an ordinary practice to mount passive devices such as capacitors and resistors on the printed wiring board carrying a semiconductor device chip in order to reduce the above-mentioned noises. But this method has a problem in that the wiring inductance tends to be large because of a long distance between the semiconductor device chip and the passive devices on the printed wiring board. Further, since the passive devices take up a substantial space on the printed wiring board, it is difficult to reduce noise or increase the mounting density beyond a certain limit.

On the other hand, in order to reduce noise most effectively, noise reduction should be provided as close as possible to the semiconductor device chip. With this arrangement, the wiring lengths can be shortened. Thus, a conventional ceramic laminated package has internal wirings in a multi-layered structure in order to reduce the power source inductance, has capacitors between internal wirings in order to bypass noise, and has internal power/ground plane means for reducing crosstalks.

Further, in order to improve the heat radiating capacity, some of conventional laminated ceramic packages are made of alumina and are provided with a heat sink made of Cu-W alloy, or made of material aluminum nitride, which is known to have a higher thermal conductivity than alumina. Also, there are known packages provided with heat radiating fins.

Such conventional ceramic laminated packages comprise a body formed by laminating a ceramic sheet suitable for formation of circuits and the mounting of high-speed device chips and a high-melting point metal sheet and baking them together, and a semiconductor mounted thereon. After connecting the semiconductor device chip to necessary parts, the package body is soaked by a cap formed of a metal plate or ceramic plate and lead pins are bonded to the outer side of the package. Such packages are difficult to mass-produce even if the manufacturing steps are automated. Thus, their production cost is rather high, Those having means for improving heat radiating capacity are especially expensive.

Also, it is rather difficult to adapt such a conventional ceramic laminated package to various purposes. For example, if it is desired to change the type of the package or the built-in circuit according to change in the intended use, it will be necessary to redesign the entire package.

In contrast, plastic package type semiconductor devices are more adapted for mass-production and can be formed by transfer molding at low cost. Further, the lead frame can be secured in position more reliably.

But this type of devices ordinarily use only a lead frame, so that it is impossible to prevent internal noise. Especially if a high-speed device chip is mounted on such a device, it is difficult to reduce noises to a satisfactory level.

One possible way to improve the heat radiating capacity or a plastic package is to provide a heat spreader made of copper alloy. In case of a ceramic package, heat sinks and heat radiating fins are used. But semiconductor devices equipped with such heat radiating means are large in volume, heavy in weight and expensive. Such packages are not suitable for use in general-purpose semiconductor devices.

Thus, there was no conventional package which satisfies all of the following four conditions: 1) inexpensive, 2) having such high anti-noise properties as to be adaptable to high-speed operation, 3) flexible to cope with a wide variety of applications, and 4) high in heat radiating capacity.

It is an object of this invention to provide a semiconductor device which has a board for mounting a semiconductor device chip, a lead frame and a laminated ceramic plate and which satisfies the abovesaid conditions 1) - 3) or 1) - 4) in a balanced manner.

From one aspect of the present invention, there is provided a semiconductor device comprising a metal board, a semiconductor device chip mounted on the metal board, a ceramic laminated wiring board having wiring layers and mounted on the metal board so as to surround the semiconductor device chip, and a lead frame bonded to the ceramic laminated wiring board through an insulating layer, the semiconductor device chip, the ceramic laminated wiring board and the lead frame having their inner portions sealed with a synthetic resin. (This structure is hereinafter referred to as the first arrangement.)

From another aspect of the present invention, there is provided a semiconductor device which is similar to the device of the first arrangement except that the ceramic laminated wiring board has a device chip mounting portion and is provided with a wiring layer on its surface and/or between its layers and/or on its back. (This structure is hereinafter referred to as the second arrangement.) This means that in the second arrangement, the metal board used in the first arrangement is replaced with a single-layer or multi-layered ceramic plate.

The ceramic laminated wiring board used in the first or second arrangement should be mainly made of aluminum nitride rather than alumina in order to insure high heat radiation.

If the wiring board is mainly made of aluminum nitride, at least the outer ends of the wiring layer provided on the surface of the wiring board may have the same shape as the inner ends of the corresponding leads of the lead frame, the leads being directly bonded to the wiring layer by soldering or hot-pressing. (This structure is referred to as the third arrangement.)

In the first and second arrangements, via holes filled with a conductive material may be formed in the insulating layer at portions right under the leads, thereby electrically connecting the lead frame to the wiring board through the conductive material in the via holes. Such via-connection may be used in combination with other connecting methods which will be shown in the description of embodiments.

In the first and second arrangements, a wiring layer may be provided on the surface of the wiring board to cover only its intermediate portion around the device chip mounting portion or to cover only its outermost portion disposed around the intermediate portion. Otherwise, two separate wiring layers may be provided on the surface of the wiring board, one on the outermost portion and the other on the intermediate portion. In any of the above three cases, the lead frame is provided on the insulating adhesive Layer so as to be disposed over the outermost portion of the wiring board. The wiring layer provided on the intermediate portion of the wiring board serves as a relay connecting the semiconductor device electrode to the lead frame. The wiring layer on the outermost portion is used as a circuit exclusively for power source or grounding.

The lead frame is preferably made of copper alloy if high heat radiation is required. The wiring layers of the wiring board may be electrically connected together through via-connection or crossover connection which will be described hereinbelow.

Further, the wiring layers of the wiring board may include a layer exclusively for grounding or power source potential, or a layer having passive devices such as resistors. Also, in order to improve the anti-noise properties, a bypass capacitor may be formed in the wiring board, utilizing two of the wiring layers as its electrodes and one of the insulating layers as its dielectric.

In order to further reduce the size of the device, the wiring layer provided on the surface of the wiring board may be formed by the film process or the above-mentioned passive devices may be film devices.

The semiconductor device according to the present invention is advantageous over the conventional semiconductor device which uses a laminated ceramic board itself as a sealing package, such as a pin grid array (PGA), in that an expensive laminated ceramic portion can be made compact in size. Such downsizing of the ceramic portion is possible because ceramics are not used for sealing the device, wire connections are made on the surface of the board, so that no extra internal wirings are necessary, and wiring layers can be formed not only on the surface of the laminated ceramic board but on other surfaces. Further, since the entire device can be resin-sealed by transfer molding, its mass-productivity is high. Thus, the semiconductor device of the present invention even with the lead frame is more inexpensive than conventional CPGA's.

By using laminated ceramic board, it is possible to form in the internal wiring a bypass capacitor having electrodes formed by some of the internal wirings or to form damping resistors or terminal resistors in the surface wiring. It is also possible to reduce the inductance of the power source circuit by providing a plurality of wiring layers or by using some of the wiring layers exclusively for power source or grounding. Thus, the device of the present invention has excellent anti-noise properties comparable to those of CPGA's. By employing a circuit arrangement in which an insulating layer between the leads and a wiring layer functions as a dielectric or a circuit arrangement in which the leads have a microstrip structure by use or the metallized layer formed on the surface, the anti-noise properties wilt improve even higher than those of CPGA's

Further, the ceramic laminated wiring board and the lead frame can be replaced with different types and the way of wiring connections can be changed. In other words, the device can be redesigned easily according to the intended use and thus can be used for various purposes.

It is possible to improve the heat radiating capacity by properly selecting the main component of the materials forming the ceramic laminated wiring board and the lead frame. For example, by forming the ceramic board from aluminum nitride, which is high in heat radiating capacity and forming the lead frame and the metal board from copper alloy, which is high in heat conductivity, the entire device will show such a high heat radiating capacity that it is possible to mount a device chip having a high heat value.

The semiconductor device of the present invention comprises a ceramic laminated wiring board and a lead frame. After mounting a semiconductor device chip and connecting it to necessary parts, the device in resin-sealed by transfer molding. Thus, its mass-productivity is high.

It is possible to increase the anti-noise properties by providing bypass capacitors or a layer used exclusively for the power source or grounding in the wiring board, by providing passive devices in the surface wirings, or by connecting the leads to the wirings through via-connection. Thus, it can be used for high-speed operation.

Further, this device can be used for various purposes, because it is possible to change selectively the internal structure of the ceramic laminated wiring board, the number of its layers, its ceramic material, the wiring pattern on the wiring board, the capacity and the mounting position of the device chip mounted on the board, the electrostatic capacity of the bypass capacitors, the material of the lead frame, and the way of connections between parts.

High heat radiating capacity can be achieved by combining a wiring board made mainly of AlN and a lead frame made of copper alloy. The semiconductor device of this invention is especially suited for use as a substitute for a conventional semiconductor device which necessarily required an expensive ceramic laminated package, such as a semiconductor device carrying a high-speed digital IC, typically an MPU, or a semiconductor device carrying a memory device required to input and output signals at, high speed. The semiconductor device according to the present invention is versatile, less expensive and of high performance.

Other features and objects of the present invention will become apparent from the following description made with reference to the accompanying drawings, in which:
Fig. 1 is an exploded perspective view of a semiconductor device of the first arrangement;
Fig. 2 is a sectional view of an embodiment of a semiconductor device of the first arrangement before resin-sealed;
Fig. 3 is a sectional view of another embodiment of a semiconductor device of the first arrangement before resin-sealed;
Fig. 4 is a sectional view of still another embodiment of semiconductor device of the first arrangement before resin-sealed;
Fig. 5 is an exploded perspective view of a semiconductor device of the second arrangement;
Fig. 6 is a schematic plan view of an example of wirings provided on the surface of the wiring board;
Fig. 7 is a schematic plan view of another example of surface wirings;
Fig. 8 is a schematic plan view of a still another example of surface wirings;
Fig. 9 is a schematic plan view of surface wirings made of films and including film resistors;
Fig. 10 is a schematic sectional view of a ceramic laminated board used in a semiconductor device of the second arrangement;
Fig. 11 is a schematic sectional view of a board formed inside with a bypass capacitor;
Fig, 12 is a plan view of the lowermost wiring for power source potential shown in Fig. 10, which is connected at four points through via-connection;
Fig. 13 is a sectional view of a laminated ceramic wiring board used in an experiment;
Fig. 14 is an exploded perspective view of a semiconductor device of the third arrangement;
Fig. 15 is a schematic plan view of an example of wirings provided on the surface of the wiring board shown in Fig. 14;
Fig. 16 is a sectional view of a laminated ceramic wiring board used in an experiment;
Fig. 17 is a sectional view of another embodiment of ceramic laminated wiring board for use in a semiconductor device of the second arrangement;
Fig. 18 is a sectional view or the wirings on the board of Fig. 17 showing how they are connected together;
Fig. 19 is a plan view showing an example of crossover connections between the wirings of the board shown in Fig. 17;
Fig. 20 is a plan view of the crossover connections of Fig. 17 in a completed form; and
Fig. 21 is a sectional view taken along line X-X of Fig. 20.

The embodiments of this invention will be described in detail with reference to the drawings.

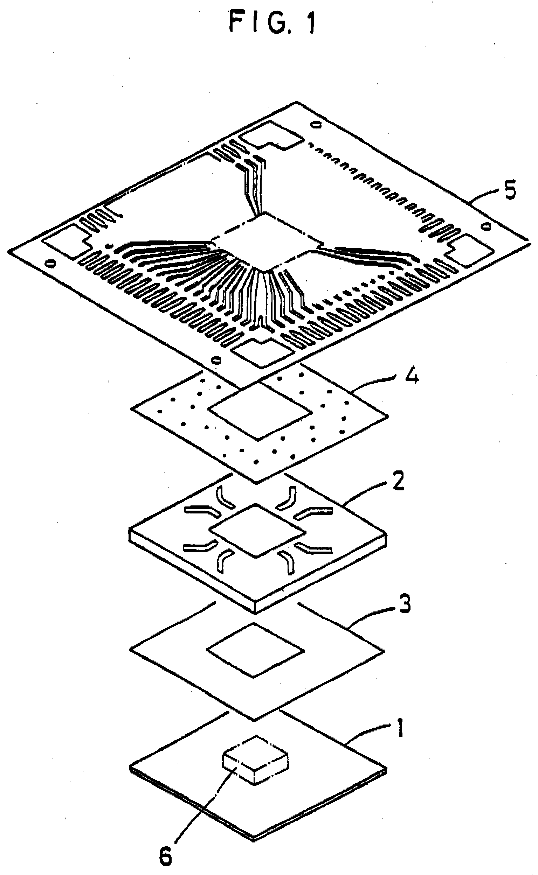

Fig. 1 is an exploded schematic view of the semiconductor device in the first arrangement. In this embodiment, the device comprises, from under to top, a metal board 1 in the center of which a semiconductor device chip 6 is to be mounted, an insulating layer 2 made of an insulating adhesive or an insulating double-aided adhesive tape, a ceramic laminated wiring board 3, an organic film 4 (such as a polyimide film) having an insulating adhesive applied to both sides thereof, and a lead frame 5 made of copper alloy or iron/nickel alloy.

Though not shown, electrical connections are provided between the semiconductor device chip 6 and the ceramic laminated wiring board 3 and between the latter and the lead frame 5. The lead frame 5 is then resin-sealed by transfer molding over the entire area except its outer portion and finally the leads are separated from one another by cutting oft the outer edge portion of the lead frame 5.

As a semiconductor device having such a basic structure, we made a plastic quad flat package (PQFP) carrying a CMOS digital logic IC device. The package is 24 x 24 x 4 (mm) in dimension and has 33 leads on each side which are arranged at the pitch of 0.64 mm.

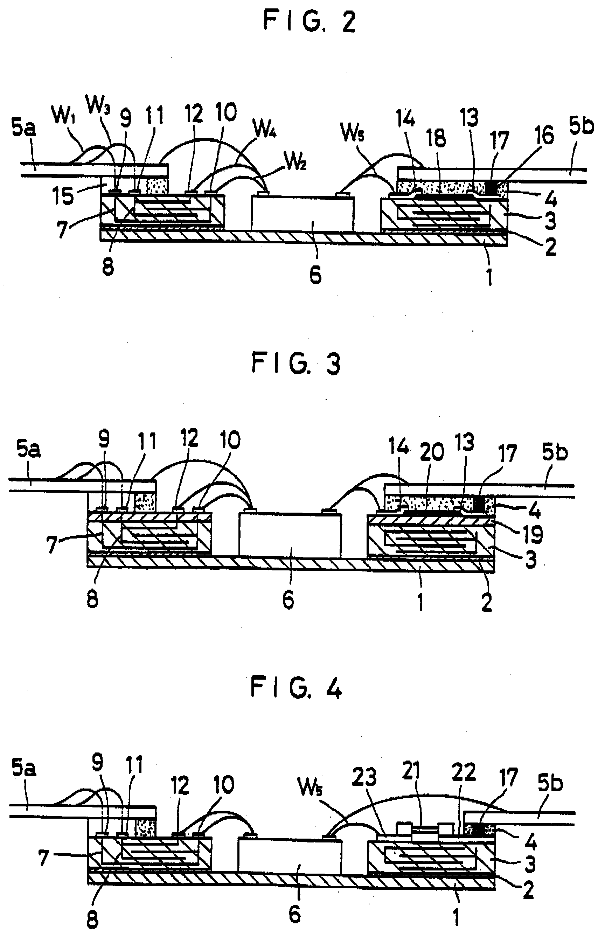

Fig. 2 shows a section of one of the semiconductor device made. The ceramic laminated wiring board 3 shown in this figure is formed by laminating and baking alumina and has a pair of comb-shaped electrodes 7 and 8 made of tungsten between the adjacent alumina layers. These electrodes 7 and 8 are formed by printing on the respective alumina layers and baking them together with the alumina layers. Inside the board 3, a capacitor is formed by the electrodes 7 and 8 and the alumina layer disposed between the electrodes as a dielectric.

The electrodes 7 and 8 are connected, respectively, to wiring: 9, 10, 11 and 12 formed on the surface of the ceramic laminated wiring board 3. Those wirings are plated with Au.

The electrode 7, is connected to a lead 5a through a wire W1 branching from the wiring 9. The wire W1 is taken from the wiring 9 by wire bonding and extends through a cutout 15 formed in the organic film 4. The electrode 7 is connected to a terminal of the semiconductor device chip 6 through a wire W2 taken from the wiring 10 by wire bonding. Thus, the lead 5a is electrically connected to the terminal of the semiconductor device chip 6 via wire W1, electrode 7 and wire W2.

Similarly, the electrode 8 is connected to another load (not shown) through a wire W3 and to the terminal of the semiconductor device chip 6 through a wire W4. Thus, assuming that the lead 5a has a power supply potential and the other lead connected to the electrode 8 has a ground potential, a noise-bypassing capacitor is provided parallel to the power supply, its electrodes being the electrodes 7 and 8. This capacitor absorbs the switching noise of the semiconductor device chip 6.

Between a pair of film wirings 13 and 14 formed on the surface of the ceramic laminated wiring board 3, a resistor 18 made of ruthenium oxide and formed by thick-film printing is inserted.

Wiring 13 is connected to a lead 5b through a conductive material 17 filling a via hole 16 formed through the organic film 4 (or through the film 4 and the lead). The conductive material may be an epoxy resin containing an Ag filler. The other wiring 14 is connected to a terminal of the semiconductor device chip 6 through a wire W5 connected by bonding. Thus, by using the load 5b, which is connected to the terminal of the semiconductor device chip 6 through the conductive material 17, resistor 18 and wire W5, to transmit high-speed signals, the resistor 16 will serve to control the waveforms of the high-speed signals, thus reducing the signal noises.

Fig. 3 shows a section of a second embodiment, In this figure, the same elements as those in Fig. 2 are denoted by like numerals and their description is omitted. We will describe only the differences from the arrangement shown in Fig. 2.

The semiconductor device shown in Fig. 3 is different from the device shown in Fig. 2 in that the ceramic laminated wiring board 3 is formed by laminating and baking aluminium nitride (AlN), that after applying a polyimide film 19 on the surface of the board 3, the wirings are formed thereon, and that a resistor 20 provided on the board 3 is formed of a film.

The surface of the ceramic laminated wiring board 3 is mirror-finished, on which is provided the polyimide film 19 by spin-coating and baking. Then, a TaN film as the resistor 20 is formed by sputtering. Film wirings are laminated further thereon to form the wirings. The film wirings are formed by laminating Cr film for bonding and Cu films shaped into a predetermined wiring pattern by vacuum deposition and providing further thereon a protective layer in the form of a chemically stable Au plating layer.

The polyimide film 19, the TaN film resistor 20 and the film wirings having a three-layer structure comprising a Cr film, a Cu film and an Au plating may be formed by photolithography In which uniformly shaped films are subjected to etching to form a predetermined pattern or by masking in which, when forming the respective films, they are individually subjected to masking to form the respective patterns one after another.

Since this semiconductor device has the noise-bypassing capacitor and the resistor 20, noise can be reduced as effectively as with the device shown in Fig. 2. Also, since the board is formed of aluminum nitride and the wirings and the passive device (resistor 20) provided on the surface of board are in the form of films, the device of this embodiment is improved in heat dissipating proparties and compactness over the device of Fig. 2.

The polyimide film 19 can be alternatively an SiOxNy insulating film formed by the CVD method. The wirings formed on this film may have a multi-layered structure comprising alternately laminated film wirings and insulating films.

Fig. 4 shows section of a third embodiment.

This device has a resistor 21, which is a chip part, mounted on a ceramic laminated wiring board 3 made vainly of alumina and/or AlN. The resistor 21 has both ends thereof soldered to wirings 22 and 23 on the board 3. On the other hand, the wiring 23 is connected to a terminal of the semiconductor device chip 6 through wire W5 and the wiring 22 is connected to the lead 5b through the conductive material 17 in the via hole. Thus, the resistor 21 is formed between the lead 5b and the semiconductor device chip 6. It serves to control the waveform of the aforementioned high-speed signals.

We manufactured PQFP samples having the above-described structure. In any sample, the bypass capacitors and resistors operated efficiently, Even when the number of switching operations was increased, the input/output signals showed no problematic waveforms. In case of conventional plastic packages (PQFP's having the same outer dimensions as the above samples) having a similar digital logic IC mounted thereon, the input/output signals showed noise waveforms.

The passive device mounted on the board 3 is not limited to a resistor. For example, a capacitor, which is a chip part, may be connected in parallel to the power supply of the semiconductor device chip 6 by forming a predetermined wiring pattern on the board 3. The capacitor can absorb switching noises of the semiconductor device chip 6. In this case, there is no need to provide a separate capacitor in the wiring board 3. Thus, the wiring board 3 may be a single-layer board having no capacitor inside. Also, the internal wiring layers lay be used exclusively for the power supply or for grounding.

In the above embodiments, instead of connecting the wirings on the ceramic laminated wiring board 3 to the leads through bonding wires, they may be connected through bonding tapes by auto-bonding through the cutouts 15. Otherwise, the leads may be directly connected at the cutouts 15 to the wirings on the board by hot-pressing or soldering. Also, they may be connected through an anisotropic conductive resin filling the cutouts 15.

On the other hand, among the leads of the lead frame, ones connected not through the wiring board but directly to terminals of the semiconductor device chip may be connected by use of bonding wires or bonding tapes.

The via-connection which utilizes the conductive material in the via holes 16 makes it possible to minimize the length of connection between the loads and the respective wirings on the wiring board and thus to further lower the noise and the inductance of the signal transmission paths. Also, this arrangement eliminates the necessity of providing a space for connection between the wirings and the loads. Thus, the size of the entire device can be reduced. Further, it is possible to adjust the impedance among the leads and the wirings by changing the positions at which the via holes are formed. For the above reasons, the signal transmission leads are preferably connected by via-connection though any of the abovementioned connecting structures may be employed.

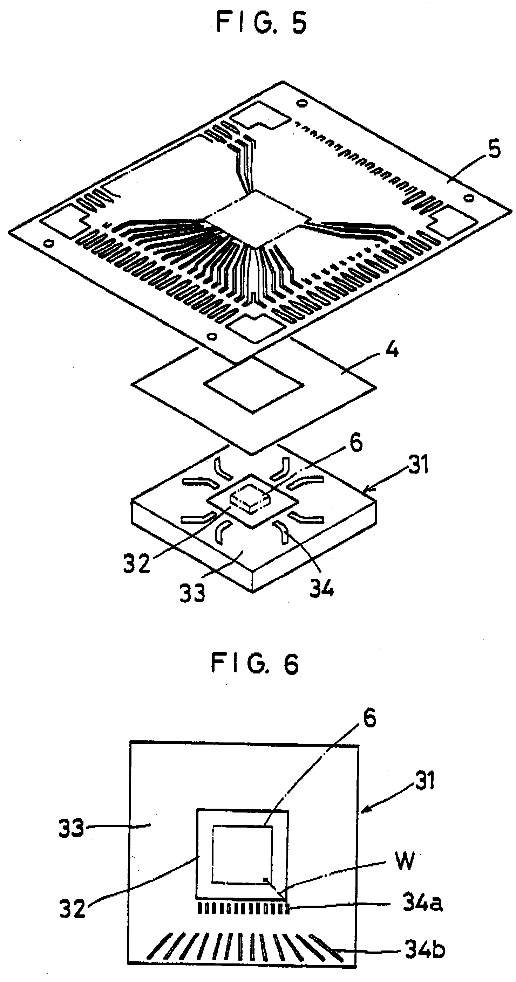

Fig. 5 shows the basic structure of a wiring board for use in a semiconductor device in the second arrangement.

A ceramic laminated wiring board 31 is provided at the central part with a device chip mounting portion 32 (which may be a cavity). A peripheral area 33 surrounds the device chip mounting portion 32. Surface wirings 34 are provided in the area 33.

The insulating organic film 4 such as a polyimide film has an insulating adhesive applied to both surfaces thereof. This organic film 4 is bonded to the peripheral area 33 and then the inner portion of the lead frame 5 is bonded to the film 4 to form a wiring board having leads. The semiconductor device chip 6 is mounted on the wiring board 31 thus formed. After connecting necessary parts together, the entire part of the load frame 5 other than its outer portion is resin-sealed. Finally, the peripheral portion of the lead frame is cut off to form the intended semiconductor device.

The organic film 4 may be omitted if a ceramic film is provided on the outermost layer of the wiring board 31 (in which case, the wiring: 34 are not surface wiring: any more).

Thus, the wiring board used in the second arrangement may be made of ceramic including the portion which is made of metal in the first arrangement. Also, the position and pattern of the wiring layers to be provided on the surface of the wiring board are not limited.

For example, in the example shown in Fig. 6, wirings 34a to be connected to the semiconductor device chip 6 through bonding wires W are provided on the inner portion or the peripheral area 33 and wirings 34b having at least their outer ends shaped so as to correspond to the inner portions of the respective leads are provided on the outer portion of the peripheral area.

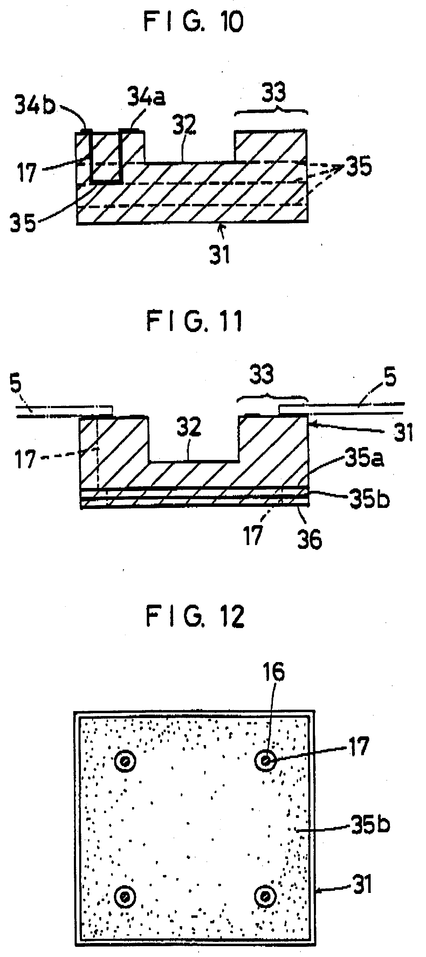

The lead frame 5 is bonded so that its leads overlie the corresponding wirings 34b through the organic film 4 shown in Fig. 5 and are electrically connected thereto by means or the via-connection as shown in Fig. 2. At least some of the wirings 34a and 34b are electrically connected together through an internal wiring 35 in the wiring board 31 as shown in Fig. 10.

This arrangement makes it possible to reduce the number of bonding wires for connecting the loads directly to the semiconductor device chip to zero or considerably ad thus to simplify the wiring and reducing the inductance of the supply line. Also, this makes it possible to form a bypass power capacitor as described above in the wiring board by using a plurality of layers of the internal wirings.

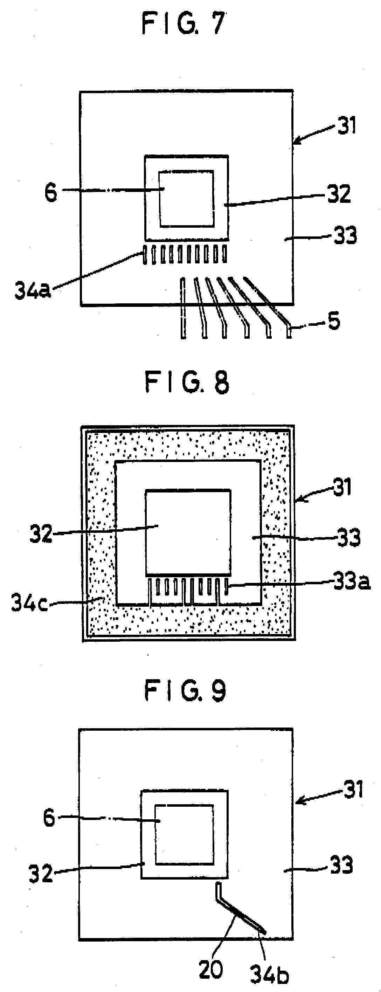

Fig. 7 shows an embodiment in which only relay wirings 34a are provided on the surface of the ceramic laminated wiring board 31. Namely, no wirings 34b as shown in Fig. 6 are provided. In this case, the lead frame is, bonded to the outer portion of the peripheral area 33 where there are no surface wirings. The leads are electrically connected to the wirings 34a through bonding wires or bonding tapes. Some of the wirings 34a are connected to the internal wirings in the board through via-connection.

In the embodiment shown in Fig. 8, a wiring 34c is provided on the outer portion of the peripheral area 33. The lead frame is bonded to the outer portion through an organic film having an adhesive applied to both sides. The grounding or power supply lead is connected to the wiring 34c through via-connection, while necessary ones of the remaining leads are connected to the semiconductor device chip via wirings 34a by bonding wires.

The wiring 34c may have the shape of a picture frame as shown or may comprise a plurality of separate parts. In the latter case, parts having a grounding potential and parts having a power supply potential may be arranged alternately with each other. In this arrangement, the leads are overlaid on the parts of the wiring 34c having a power supply potential and parts having a grounding potential through the insulating layer. In other words, the leads thus formed have a micro-strip structure. Thus, the noise in the leads can be reduced though depending on the electrostatic capacity of the interposed insulating layer.

In the embodiment of Fig. 8, the wiring 34c has a grounding potential, i.e. a grounding wiring 34a is connected to the wiring 34c. But the wiring 34c may be isolated from any other wirings.

In the second arrangement, too, the leads are preferably connected to corresponding wirings through via-connection for the aforementioned reason. But other connections may be employed together with via-connection.

If high heat radiation is desired, the wiring board may be made of AlN having a high thermal conductivity instead of ceramic or the lead may be made of a copper alloy having a high thermal conductivity. Both may be employed.

If it is desired to maintain high accuracy in dimensions and shape of the wirings provided on the surface of the ceramic laminated wiring board used as a part of a bonding pad or a circuit, the surface wirings should be in the form of thin films. Film wirings having high accuracy in shape and a fine pitch are obtainable by mask deposition or by etching after formed into films. Film may be formed out by any desirable method selected from vacuum deposition, ion plating, sputtering, CVD and plasma CVD.

By providing surface wirings in the form of films, it becomes possible to add the film resistor 20 in each wiring 34b as shown in Fig. 9 or to branch each wiring and provide a similar film resistor at the end of each branch. The former resistor serves as a "damping resistor" and the latter serves as a "terminal end resistor". Either resistor improves the electric properties of the signal lines. Chip resistors may be used in place of the film resistors though film resistors are advantageous in that they take up lesser apace and can be assembled easily.

In order to further reduce the noise, a layer essentially for grounding or power supply potential may be provided in the wiring layer of the wiring board including the surface wirings, thereby separating the wirings for the ground or power supply.

In order to effectively remove power source or grounding noise, a plurality of layers of internal wirings may be formed in the wiring board to form a bypass capacitor using these wirings as electrodes. In this case, by providing layer exclusively for grounding or power source so as to sandwich the insulating layer which serves as a dielectric, the area of the capacitor can be increased and thus the noise can be reduced still more effectively.

In order to remove noise effectively even if a high-speed device is mounted, the bypass capacitor should preferably have an electrostatic capacity of at least 500 pF. By providing wiring layers exclusively for power source and grounding, a capacitor having such a high capacity can be formed easily. For example, by providing two or more AlN layers each having on area of 400 mm² and a thickness of about 100 microns, a capacitor having an electrostatic capacity of 500 pF or more can be formed.

Fig. 11 shows a section of such an arrangement, in which an internal wiring 35a and a wiring 36 provided on the back have a source potential while a wiring 35b has a grounding potential. Two AlN layers are sandwiched by them and serve as a capacitor. The respective wirings 35a, 35b and 36 are flat layers having their entire surfaces metallized and having substantially the same contour as the ceramic laminated wiring board 31 as they are viewed from top. As shown in Fig. 12, the wiring 36 can be connected easily to the power source by means of via-connections a conductive material 17 filling the via holes 16.

An ordinary lead frame has its inner end cut so that its inner edge will coincide with the contour of the cavity. In case of the lead frame 12 according to this invention, it is necessary to change its length or the position of the inner end depending upon which one of the above-mentioned connecting methods to choose and whether or not the surface wirings to be connected include film resistors.

Table 1 shows the improvement in the heat dissipating properties and high speed property (noise reduction) for each element of the wiring boards of the devices of the second arrangement.

As is apparent from this table, the most desirable wiring board for use in the semiconductor device of the second arrangement is one which comprises a lead frame made of copper alloy and a laminated ceramic plate made mainly of AlN, the laminated ceramic plate containing a wiring layer used exclusively for power source or grounding and further containing a bypass capacitor, and a surface wiring in the form of a film wiring with a film resistor added.

Experiments were conducted in order to confirm the effect of the wiring board for use in the semiconductor device of the second arrangement. The results are shown below.

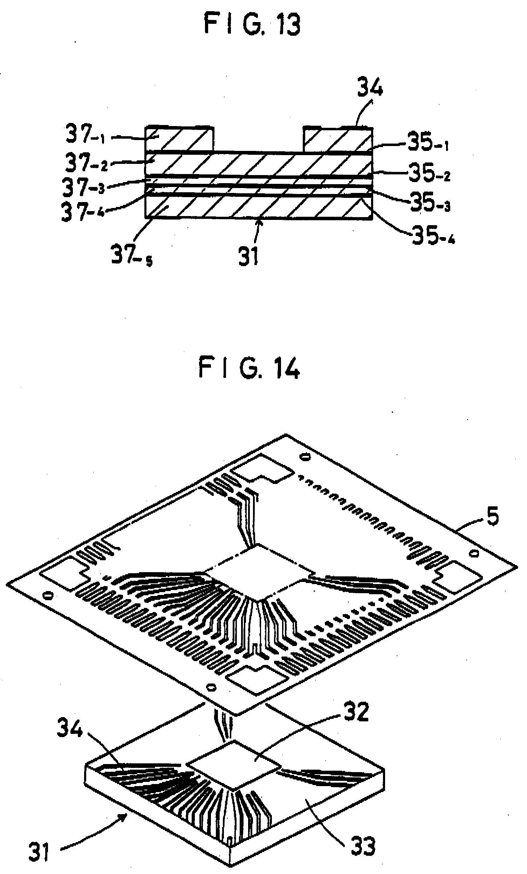

First, we prepared parts for use in the experiments.
A: 28 x 28 mm five-layer ceramic laminated wiring boards made of AlN. The center cavity was a 13 x 13 mm square. The surface wiring had a shape complementary to the shape of the inner portion of the lead frame. Its section is shown in Fig. 13. An internal wiring 35-3 provided between ceramic layers 37-3 and 37-4 was a metallized layer used exclusively for power source and a wiring 35-2 between ceramic layers 37-2 and 37-3 and a wiring 35-4 between 37-4 and 37-5 were metallized layers used exclusively for grounding. These wirings were formed by baking together with the ceramic layers. After baking, Ni and Au were plated, respectively, to the surface of the surface wiring 34 and the surface of the wiring 35-1 exposed at the bottom of the cavity. The ceramic layers 37-1 to 37-5 had thicknesses of about 0.3, 0.3, 0.1, 0.1 and 0.3 mm, respectively.
   Basically, the wirings were connected together through via-connection. Comparative boards were formed which were different from one another in that via-fills are provided or not. Namely, in A-3, all the wirings were connected together through via-connection, in A-2, the internal wirings 35-3 and 35-4 were not connected to the surface wiring 34 and in A-1, the internal wirings 35-2, 35-3 and 35-4 were not connected to 34.
   We also prepared a wiring board A-4 which had no surface wiring 34 and A-5 in which the surface wiring 34 was not a patterned wiring but an overall metallized wiring.
   Further, we prepared a wiring board A-6 which were formed using the board A-4 and in which the surface wiring 34 in the shape of a lead frame was formed by film (Au/Ni/Al) process, and A-7 in which the Au/Ni/Al layers on the adjacent five of the film wirings 34 corresponding to a pin 208 were partially removed and NiCr film resistors of 50 ± 5 ohms were formed at these portions by sputtering. The materials Au/Ni/Al and NiCr used herein are mere examples.
B: 208-pin quad lead frames made of copper alloy and having an outer pitch of 0.635 mm. Two such lead frames were prepared, having different lead lengths. One of the lead frame: (B-1) had all of its leads extending just to the edge of the cavity. The other lead frame B-2 has the inner end of the leads located apart from the cavity edge by 2.5 mm (the inner area of the lead frame delineating an 18 x 18 mm square).

### Experiment 1

The ceramic laminated wiring boards A and the lead frames B thus prepared were combined and bonded together in the following manners a) to e) and the assemblies thus formed were resin-molded to give them the shape of 35 x 35 mm square. They were then subjected to a temperature-cycle test (150°C ← → -65°C). It was confirmed in this test that none of the specimens suffered peeling or wire breakage up to 500 cycles and that they can sufficiently withstand the actual use.
a: A-1 and B-1 were bonded together by means of Au-Sn solder (known CQFP).
b: A-4 and B-2 were bonded together by means of polyimide film with adhesive (assembly according to the present invention).
c: A-5 and B-2 were bonded together by means of polyimide film with adhesive (assembly according to the present invention).
d: A-1 was bonded to B-2 having 30 leads formed with via holes about 0.15 mm in diameter by means of polyimide film with adhesive. Via holes were formed in the polyimide film at portions corresponding to the via holes in the leads and they were filled with an Ag-containing epoxy resin for via-connection. (assembly according to the present invention).
e: A-6 and B-2 were bonded together by means of polyimide film with adhesive (assembly according to the present invention).

### Experiment 2

Lead frame B-2 was bonded to each of the laminated ceramic boards A-1, A-2, A-3 and A-7 by means of polyimide film with adhesive and connection was made by wire bonding to examine their electrical properties.

A-2 and A-3 were used to form bypass capacitors inside. Specimens using A-1 showed an electrostatic capacity of about 80 pF between power source and ground at 1 MHz. The specimens using A-2 showed about 200 pF and the specimens using A-3 showed about 1.2 nF. The specimens using A-1 were not only low in electrostatic capacity, but the capacity varied widely. Thus, they were considered unreliable.

On the other hand, A-7 has a film resistor in the surface wiring. This resistor is provided no that it will function as a damning resistor for checking overshooting of the signal potential. But it will serve the same purpose if provided so as to function as a terminal resistor for absorbing reflected noise.

A CMOS digital IC was mounted on the wiring board comprising A-7 and B-2 and the waveforms of its input and output signals were checked. No problematic noise or waveforms were observed. The film resistor formed on A-7 had a resistance of 50 ohms. This value is adjustable according to the semiconductor device chip to be mounted.

### Experiment 3

In this experiment, the samples were checked for heat resistances.
Sample 1: A 10 x 10 mm IC device chip was mounted on B-1 (which had a 13 x 13 mm die pad) and necessary parts were connected together by wire bonding. The assembly thus formed was resin-molded.
Sample 2: The same IC device chip as that used in Sample 1 was mounted on a lead frame (carrying a 13 x 13 mm die pad) similar to B-1 except that it is formed of alloy 42 which is low in heat conductivity and necessary parts were connected together by wire bonding. The assembly thus formed was resin-molded.
Sample 3: A-1 and B-1 were bonded together through a polyimide film having adhesive applied to both sides and necessary parts were connected together by wire bonding. The assembly thus formed was resin-molded. The thermal conductivity of A-1 was 155 W/m·k.
Sample 4: A-1 made mainly of not AlN but Al₂O₃ which is low in thermal conductivity was bonded to B-1 through a polyimide film having adhesive attached to both sides. A device chip was mounted thereon and necessary parts were connected by wire bonding. The assembly thus formed was resin-molded.

These samples 1 to 4 had thermal resistances (measured in windless state from the junction to the peripheral part at 1 Watt) of 35, 55, 20 and 35 (°C/w), respectively. This shows that it is preferable to use a lead frame made or copper alloy and a laminated ceramic made of AlN.

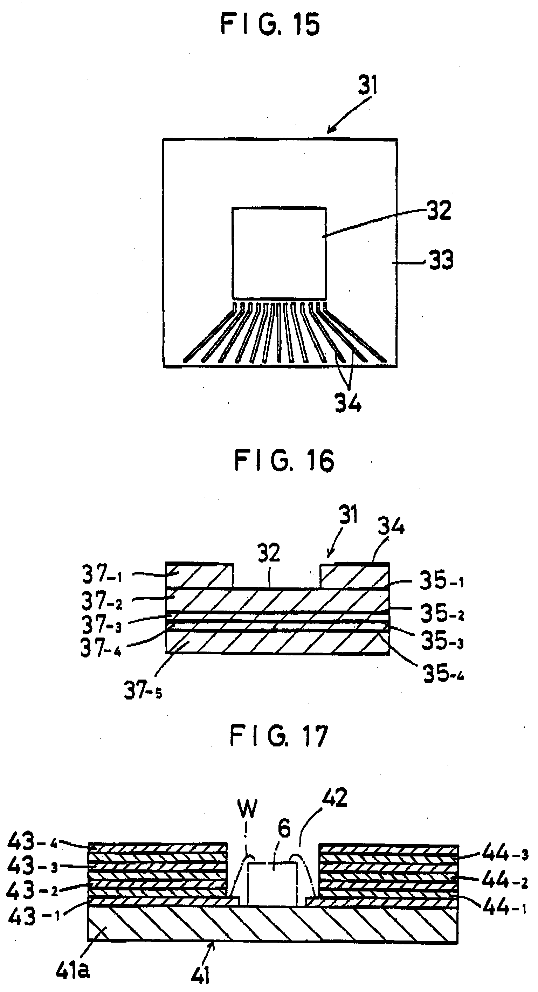

Fig. 14 shows a basic structure of the wiring board for use in the semiconductor device of the third arrangement. With the ceramic laminated wiring board 31 shown in this figure, AlN is used for the ceramic layer. The wiring board 31 may have a wiring layer only on the surface. But in order to provide wiring layers used exclusively for power source and grounding or to provide internal bypass capacitors, it is preferable to provide such wiring layers between layers and on the backside, too. As shown in Fig. 15, the surface wirings 34 on the wiring board 31 have the same shape as the overlying inner portions of the leads of the lead frame 5, at least at their portions located in the outer area of the peripheral region 33.

The lead frame 5 is made of copper alloy and has the inner portions of its leads electrically connected directly to the wirings 34 by soldering or hot-pressing that causes heat diffusion. When mounting a device chip having a large calorific value, this wiring board is preferable for high reliability because no organic materials are used.

For the same reason, the surface wirings 34 provided on the wiring board of Fig. 14 should preferably be formed of film wirings made by film processing.

Film resistors (or chip resistors) as shown in Fig. 9 may be provided in the surface wirings if the wiring board 31 is used. It is, of course, possible to provide layers used exclusively for grounding or power source in the board or to form a bypass capacitor having an electrostatic capacity of 500 pF or more in the wiring board. In this case, the wirings may be connected together in the manner as shown in Fig. 11 or Fig. 12.

The wiring board of the third arrangement, too, shows heat dissipating properties and adaptability to high speed that are the same as shown in Table 1. Thus, the most desirable wiring board in this arrangement is one which include layers used exclusively for grounding or power source and a bypass capacitor and has film wirings including film resistors.

The wiring boards of the third arrangement were tested for their various properties. The results are described below.

We prepared 5-layer ceramic wiring boards C-1, C-2 and C-3 which are the same as the above-described wiring boards A except that their surface wirings have different patterns. Their sectional shape is shown in Fig. 16. In C-3, all the wirings are connected together through via-connection. In C-2, the internal wirings 35-3 and 35-4 are not connected to the surface wirings 34. In C-1, the internal wirings 35-2, 35-5 and 35-4 are not connected to the surface wirings 34. We also prepared a single-layer AlN ceramic board C-8 (having surface wirings and plating layers that are the same as those of C-1) in the shape of a 28 x 28 mm square having a thickness of 1.1 mm.

Further, we prepared a wiring board C-4 having surface wirings 34 having the same shape as the lead frame and formed by film (Au/Ni/Al) processing, and a wiring board C-5 in which adjacent five of the film wirings 34 corresponding to the pin 208 had portions where Au/Ni/Al layers were missing and film resistors (NiCr) having a resistance of 50 ± 5 ohms were formed at these portions by sputtering.

Also, we prepared a 1.1-mm thick single-layer ceramic board C-6 having the same shape as above and having film wirings (Au/Ni/Al) having the same shape as the lead frame and formed by, the film-forming process as with C-4, and a wiring board C-7 in which, as with C-5, adjacent five of the film wirings corresponding to the pin 208 had film resistors (NiCr) having a resistance of 50 ± 5 ohms and formed by sputtering.

The above-mentioned various materials for the film wirings are mere examples.

### Experiment 4

The respective wiring board: C-1 to C-8 were bonded to 208-pin quad type Lead frames B-2 made of copper alloy as used in Experiments 1 and 2 in the following combinations f) to k). The assemblies thus formed were resin-molded into the shape of 35 x 35 mm square. They were subjected to temperature-cycle tests (150°C ← → -65°C). None of the specimens suffered peelings or broken wires up to 500 cycles.
f: B-2 was bonded to C-1 by means of Au-Sn solder.
g: Sn-plated B-2 was directly bonded to C-1.
h: B-2 was bonded to C-4 by means of Au-Sn solder.
i: fin-plated B-2 was directly bonded to C-6.
j: B-2 was bonded to C-7 by means of Au-Sn solder.
k: B-2 was bonded to C-8 by means of Au-Sn solder.

### Experiment 5

Lead frames B-2 were bonded to respective boards C-1, C-2, C-3 and C-5 by means of Au-Sn solder and after connecting necessary parts together by wire bonding, their electrical properties were examined.

C-2 and C-3 were used to form bypass capacitors inside. The specimens using C-1 showed an electrostatic capacity of about 80 pF between the power source and ground as measured at 1 MHz. The specimens using C-2 showed about 200 pF and the specimens using C-3 showed about 1.2 nF. These results are the same as the results of Experiment 2.

C-5 includes in the surface wirings film resistors (having a resistance of 50 ohms) which function as damping resistors. A CMOS digital IC device chip was mounted on the wiring board comprising C-5 and B-2 and the waveforms of its input and output signals were examined. No particularly problematic noise or waveforms appeared.

Though we have not prepared for this experiment, it is possible to use a wiring board having a ceramic layer 37-5 provided on the back with a wiring layer to be used exclusively for grouding potential.

### Experiment 6 (Comparison of thermal resistance)

Sample 5: Only B-2 was resin-molded.
Sample 6: Only a lead frame having the same specification as B-2 and using alloy 42, which is low in thermal conductivity, was resin-molded.
Sample 7: C-1 and B-2 were bonded together through Au-Sn solder and then resin-molded.
Sample 8: B-2 was bonded to a wiring board similar to C-1 but made of Al₂O₃ (low in heat conduction) instead of AlN through Au-Sn solder and the assembly thus formed was resin-sealed.

Samples 5 - 8 showed thermal resistances of 35, 55, 20 and 35 (°C/w), respectively, in a no-wind condition. This result shows that the combination of a lead frame made of copper alloy and a ceramic board made mainly of AlN is the most desirable in improving heat dissipating properties.

Fig. 17 shows a variant of the semiconductor device in the second arrangement. A ceramic laminated wiring board 41 used in this embodiment comprises a single-layered board 41a made mainly of AlN having a thermal conductivity of about 170 w/mk, and N (N ≧ 2) wiring layers and (N ± 1) insulating layers laminated alternately on the board 41a. In the figure, wiring layers 43-1, 43-2, 43-3 and 43-4 and insulating layers 44-1, 44-2 and 44-3 are laminated alternately with each other. These layers have the shape of picture frames. A semiconductor device chip 6 is mounted in the central cavity 42 defined by these layers.

The wiring layers 43-1 to 43-4 are formed by metallizing Al films and have a predetermined pattern. For example, the pattern may be formed by a plurality of wirings 7 mm long and 0.2 mm wide which are arranged at the intervals of 0.2 mm.

The insulating Layers 44-1 to 44-3 are made by forming SiO₂ films with the plasma CVD method.

The wining layer 43-1 has its inner and extending into the cavity 42 and connected to the semiconductor device chip 6 through bonding wires W or bonding tapes. Other wiring layers may be connected to the semiconductor device chip 6. In other words, some of the wiring layers are connected to the semiconductor device chip.

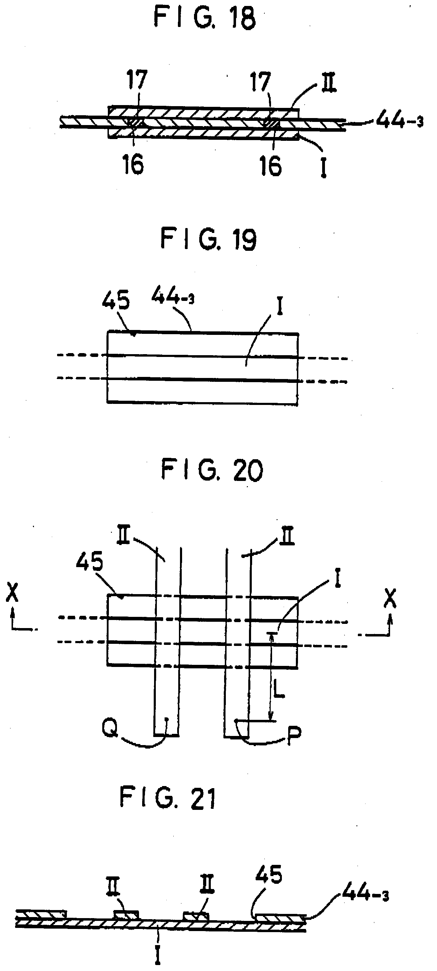

Fig. 18 shows one way of connection between wiring layers. In this example, a wiring I in the wiring layer 43-3 and a wiring II in the wiring layer 43-4 are connected together through via-connection. A via hole 16 is formed in the insulating layer 44-3 by plasma etching using CF₄.

### Experiment 7

Wiring I and II both 5 mm thick, 0.2 mm wide and 7 mm long (specific resistance: 3µΩ·cm) were formed by metallizlng on a 28 x 28 mm single-layer board made of AlN and having a 13 x 13 mm cavity. Via holes 16 having a diameter of 0.15 mm were formed in the film insulating layer of SiO₂ formed by the plasma CVD method at portions 1 mm away from both ends of these wirings. The holes thus formed were filled with a conductive material 17 (epoxy resin containing an Ag filler). Then, the resistance between each end of the wiring II and a point 0.5 mm apart therefrom was measured.

The resistance was 90 ± 5 mΩ, which is smaller than the resistance at both ends of the wiring II if it is independent. With a structure which includes an additional insulating layer and a layer connected thereto through via-connection, the resistance was about 70 mΩ. The resistance at the via-connected portions is presumably about 15 mΩ. Thus, the anti-noise properties can be improved by connecting wirings in different layers in parallel to each other through via-connections.

Figs. 19 to 21 show other ways of connecting wiring layers together. In this arrangement, as shown In Fig. 19, cutouts 45 are formed in an insulating layer 44-3 provided on a wiring I. Then, as shown in Fig. 20, wirings II are formed so as to extend perpendicular to the underlying wiring I.

As shown in Fig. 21, the metallized wirings II are in contact with the underlying wiring I at the cutout 45, so that the wirings I and II are electrically connected together. This arrangement is hereinafter referred to as a crossover structure. It provides a similar effect to that obtainable with the via-connection.

### Experiment 8

Cross-wirings were formed on a single-layer board by AlN in the shape of a 28 x 28 mm square having a 13 x 13 mm cavity, with a film insulating layer made of SiN provided between the cross-wirings. An underlying layer I and two overlying wirings II were each 5 mm thick, 0.2 mm wide and 7 mm long (specific gravity: 3µΩ·cm). The resistance between points P and Q on each of the overlying layers II (L = 2.9 mm) was measured. It was 320 ± 10mΩ. The contact resistance at the crossover portion between the wirings I and II is presumed to be around 10mΩ. Thus, this structure can also be used as effective means for connecting together the wiring layers in the board.

It is of course possible to utilize the via-connection in combination with the crossover connection.

Also, resistor elements may be provided between any desired adjacent wirings in the uppermost wiring layer 43-4.

### Experiment 9

Resistors 0.15 mm wide and 1.5 mm long having a resistance of 50 ± 5 ohms were provided between surface wirings. They were formed by sputtering NiCr thin-films having a sheet resistance of 10 ohms. A CMOS digital IC device was mounted in the cavity in the wiring board and connected to the leads (not shown) through the resistors to form signal transmission lines. We examined the waveforms of the signals that are transmitted in the signal lines. No especially problematic noise or waveforms were found.

The resistance of the resistor films can be adjusted to any desired value. In the illustrated arrangement, the resistor films serve as damping resistors. But, as described above, they may be arranged so as to serve as terminal resistors.

Also, as shown in Figs. 11 and 12, wirings separated by at least one wiring layer way be connected together through via-connection, Further, it is possible to form a bypass capacitor for reducing switching noise inside the wiring board. In this case, an intermediate insulating layer serves as the dielectric and the wiring layers on both sides as the electrodes,

### Experiment 10

A bypass capacitor was formed which comprised the wiring layers 43-1 and 43-3 shown in Fig. 17 as one of the electrodes, the wiring Layers 43-2 and 43-4 as the other electrode, and the insulating layers 44-1, 44-2 and 44-3 sandwiched therebetween as the dielectric. Each wiring layer had an area of 530 mm² and each film insulating layer SiO₂ was 5 mm thick. The electrostatic capacity of this capacitor was about 11 nF at the measuring frequency of 1 MHz. A similar capacitor comprising two wiring layers and one insulating layer had an electrostatic capacity of about 3.5 nF. A capacitor comprising three wiring layers and two insulating layers had a capacity of about 7.5 nF. Thus, these values are substantially in a proportional relationship. We also found out that the electrostatic capacity of the capacitor comprising two wiring layers and one insulating layer increases to about 6 nF when the insulating layer was replaced with an insulating layer made of Al₂O₃ and formed by ion plating. Thus, if a large electrostatic capacity is desired, insulating layers made or Al₂O₃ may be used or the number of wiring layers and insulating layers may be increased. We also prepared a wiring board in which the wiring layers are partially made of Au or Au/Ni/Al. But, this turned out to have substantially no influence on the capacity.

The material or the insulating layers 44 is not limited to SiO₂. They may be SiN films or films made of silicon oxynitride. Each insulating layer may be made of a mutually different material according to the intended use of each layer.

Wiring layers 43 may be formed by printing. Printed wirings will not be expensive as long is they are baked together with the ceramic forming the board,

Unlike the ceramic laminated wiring boards shown in Figs. 10 and 11, the one shown in Fig. 17 has no internal wiring layers at the area below the device chip mounting surface but has basically the same structure as the wiring boards in the second arrangement. Thus, the concept of the first or second arrangement is applicable in forming surface wirings, bonding the lead frame and connecting the semiconductor device chip to the lead frame.

Also, as shown in Fig, 14, the device of the third arrangement may be formed by bonding the lead frame directly to the surface wirings.

### Experiment 11

We prepared a wiring board D-1 having the same structure as prepared in Experiment 7, a wiring board D-2 having the same structure as D-1 except that its surface wiring pattern is designed so that no wirings exist in the outer area extending along the edge and having a width of 4.5 mm, and a wiring board D-3 having the same structure as D-1 except that the 4.8-mm wide outer area extending along the outer edge is formed with a wiring all over the surface, and the area inside the 4.8-mm wide outer area is provided with wirings having an ordinary pattern. We also prepared a lead frame B-3 of copper alloy having a pitch of 0.4 mm (same as the pitch of the wiring pattern in D-1) and having a 14 x 14 mm square inner area, a lead frame B-4 having the same structure as B-3 except that it is plated with Sn, and a lead frame B-5 having the same structure as B-3, except that it has a 19 x 19 mm square inner area.

The wiring boards and the lead frames were combined and bonded together in the following manners and the assemblies thus formed were resin-sealed into the shape of 35 x 35 mm square. They were then subjected to a temperature-cycle test (150°C,← → -65°C). The results of the test after 500 cycles were the same as those in Experiment 1 and had no problems whatsoever.
l: D-1 and B-3 were bonded together by means of polylmide film with adhesive.
m: D-1 and B-5 were bonded together by means of polyimide film with adhesive.
n: D-2 and B-5 were bonded together by means of polyimide film with adhesive.
o: D-3 and B-5 were bonded together by means of polyimide film with adhesive.
p: D-1 and B-3 were bonded together by means of Au-Sn solder.
q: D-1 and B-4 were bonded together by means of Au-Sn solder.

### Experiment 12

We prepared Sample 9 comprising the board D-1 and the lead frame B-3 which were directly bonded together by means of Au-Sn solder and Sample 10 which comprises a board made of Al₂O₃ and the lead frame B-3 which are directly bonded together through Au-Sn solder. A transistor was mounted on each sample and their thermal resistances with the power consumption kept at 1 W were compared. In a windless condition, Samples 9 and 10 showed thermal resistances of 15°C/W and 30°C/W, respectively. This result clearly shows that the board made of AlN has a high heat radiating capacity.

In any of the embodiments of the first and second arrangements, the leads are bonded to necessary parts on the board through an adhesive-backed organic film. But as long as insulation is assured, they may be connected together through an insulating adhesive only with the organic film omitted.

**Table 1**

| | | | High-speed adaptability | | |
|---|---|---|---|---|---|
| | | Heat dissipation | Has switching noise reduced? | Has signal line noise reduced? | Remarks |
| Lead frame | Cu alloy | ⃝ | △ | △ | |
| | Fe-Ni alloy | X | - | X | |
| Laminated ceramic | Mainly AlN | ⃝ | - | - | |
| | Mainly alumina | X | - | - | |
| | Alumina + heat sink | ⃝ | - | - | Expensive heavy |
| Structure of laminated ceramic | Film wirings | - | - | △ | |
| | Including film resistors | - | - | ⃝ | |
| Laminated ceramic having bypass internal capacitor | | - | ⃝ | - | |
| Having layer only for grounding or source potential | | - | ⃝ | ⃝ | |
| ⃝ improvable △ improvable slightly X not improvable - inapplicable | | | | | |

## Claims

1. A semiconductor device comprising a metal board, a semiconductor device chip mounted on said metal board, a ceramic laminated wiring board having wiring layers and mounted on said metal board so as to surround said semiconductor device chip, and a lead frame bonded to said ceramic laminated wiring board through an insulating layer, said semiconductor device chip, said ceramic laminated wiring board and said lead frame having their inner portions sealed with a synthetic resin.

2. A semiconductor device comprising a ceramic laminated wiring board having a device chip mounting portion on the surface thereof and provided with a wiring layer on its surface and/or between its layers and/or on its back, a lead frame having a plurality of leads and bonded to said wiring board through an insulating adhesive layer, and a semiconductor device chip mounted on said device chip mounting portion of said wiring board, at least some of the leads of said lead frame being electrically connected to said semiconductor device chip through said wiring layer of said ceramic laminated wiring board, said semiconductor device chip, said ceramic laminated wiring board and said lead frame having inner portions thereof sealed with a resin.

3. A semiconductor device as claimed in claim 2 wherein said ceramic laminated wiring board comprises a ceramic board made mainly of aluminum nitride and carrying said semiconductor device chip in the center thereof, and at least two wiring layers and at least one insulating layer which are laminated so as to alternate with each other on said ceramic board.

4. A semiconductor device as claimed in any of claims 1 - 3 wherein said insulating layer is formed with via holes filled with a conductive material at portions right under some of the leads of said lead frame, some of said leads being electrically connected to said wiring layer of said wiring board through the conductive material in said via holes.

5. A semiconductor device as claimed in claim 4 wherein portions of the wiring layer or said wiring board that are connected to said some of the leads through said conductive material in said via holes have substantially the same shape as the inner portions of said some of the leads.

6. A semiconductor device as claimed in any of claims 1 - 3 wherein some of the leads of said lead frame are electrically connected through bonding wires, bonding tapes or an anisotropic conductive resin, or directly by hot pressing or soldering, to the wiring layer of said wiring board.

7. A semiconductor device as claimed in any of claims 1 - 6 wherein the wiring layer provided on the surface of said wiring board covers only its intermediate portion around the element mounting portion and wherein said lead frame is bonded to on outermost portion of said wiring board around said intermediate portion through said insulating adhesive layer, the leads of said lead frame being electrically connected to said semiconductor through said wiring layer.

8. A semiconductor device as claimed in any of claims 1 - 6 wherein the wiring layer is provided on the surface of said wiring board only at its outermost portion disposed around an intermediate portion surrounding said innermost device chip mounting portion and wherein said lead frame is bonded to said outermost portion through said insulating adhesive layer, said wiring layer provided on said outermost portion of said wiring board being electrically connected to a power source lead or grounding lead.

9. A semiconductor device as claimed in any of claims 1 - 6 wherein two separate wiring layers are provided on the surface of said wiring board, one of said wiring layers covering an outermost portion disposed around an intermediate portion surrounding said innermost device chip mounting portion and the other wiring layer covering said intermediate portion, and wherein said lead frame is bonded to said outermost portion through said insulating adhesive layer, the leads of said lead frame being electrically connected to said semiconductor device chip through the wiring layer provided on said intermediate portion, the wiring layer provided on the outermost portion being electrically connected to a power source lead or a grounding lead.

10. A semiconductor device comprising a ceramic wiring board having on its surface a device chip mounting portion and provided with a wiring layer on the surface or on the surface and between its layers, or on its surface and its back, or on its surface, between its layers and on its back, said wiring board being mainly made of aluminum nitride, a lead frame having a plurality of leads and directly bonded to the wiring layer provided on the surface of said wiring board by soldering or by hot pressing, said wiring layer having outer end portions each corresponding to the respective leads of said lead frame, and having substantially the same shape as the inner portion of the respective leads, and a semiconductor device chip mounted on said device chip mounting portion, the leads of said lead frame being electrically connected to the semiconductor device chip through the wiring layers of said wiring board, said semiconductor device chip, said ceramic wiring board and said lead frame having inner portions sealed with a resin.

11. A semiconductor device as claimed in any of claims 1, 2 and 4-10 wherein ceramic which is the main component of said wiring board is alumina or aluminum nitride.

12. A semiconductor device as claimed in any of claims 1 - 11 wherein said lead frame is made of copper alloy.

13. A Semiconductor device as claimed in any of claims 1 - 12 wherein some of the wiring layers of said wiring board are electrically connected together through via-connection.

14. A semiconductor device as claimed in any of claims 1 - 13 wherein at least one of the insulating layers between the wiring layers are provided with cutouts, whereby the wiring layers on both sides of said insulating layer are directly connected together at the cutout portions.

15. A semiconductor device as claimed in any of claims 1 - 14 wherein one of the wiring layers of said wiring board is a layer used exclusively for grounding or power source potential.

16. A semiconductor device as claimed in any of claims 1 - 15 wherein a bypass capacitor is formed in said wiring board, said bypass capacitor comprising two wiring layers functioning as the electrodes and an insulating layer disposed between said two layers functioning as the dielectric.

17. A Semiconductor device as claimed in claim 16 wherein said bypass capacitor has an electrostatic capacity of 500 pF or more.

18. A semiconductor device as claimed in any of claims 1 - 17 wherein at least the wiring layer formed on the surface of said wiring board is a film wiring layer formed by the film process.

19. A semiconductor device as claimed in any of claims 1 - 18 wherein at least one of the wiring layers of said wiring board is provided with passive devices such as capacitors or resistors.

20. A semiconductor device as claimed in claim 19 wherein said passive elements are film devices and are provided at intermediate portions or branched ends of the film wirings formed on the surface of or inside said wiring board.

21. A semiconductor device as claimed in claim 19 wherein said passive devices are elements of chip parts and are provided in the wiring layer formed on the surface of said wiring board.
